(19) **Europäisches Patentamt / European Patent Office / Office européen des brevets**

(11) **EP 4 202 935 A1**

(12) # DEMANDE DE BREVET EUROPEEN

(43) Date de publication:
**28.06.2023 Bulletin 2023/26**

(21) Numéro de dépôt: **22212679.9**

(22) Date de dépôt: **11.12.2022**

(51) Classification Internationale des Brevets (IPC):
**G11C 13/00** *(2006.01)*    **G06F 11/10** *(2006.01)*
**G11C 29/52** *(2006.01)*

(52) Classification Coopérative des Brevets (CPC):
**G11C 13/0069; G06F 11/1048; G11C 29/52;**
G11C 2013/0083

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**KH MA MD TN**

(30) Priorité: **23.12.2021 FR 2114446**

(71) Demandeur: **Commissariat à l'énergie atomique et aux énergies alternatives**
**75015 Paris (FR)**

(72) Inventeurs:
• **GIRAUD, Bastien**
  **38054 GRENOBLE Cedex 09 (FR)**
• **GHERMAN, Valentin**
  **38054 GRENOBLE Cedex 09 (FR)**
• **EVAIN, Samuel**
  **38054 GRENOBLE Cedex 09 (FR)**

(74) Mandataire: **Atout PI Laplace**
**Immeuble "Visium"**
**22, avenue Aristide Briand**
**94117 Arcueil Cedex (FR)**

(54) **PROCÉDÉ D'ÉLECTROFORMAGE UTILISANT UN ECC LINÉAIRE INVARIANT À L'INVERSION ET DISPOSITIF ASSOCIÉ**

(57) La présente invention concerne un procédé d'électroformage d'une mémoire résistive d'un dispositif mémoire incluant un contrôleur mémoire, un encodeur calculant un code correcteur d'erreur linéaire et invariant à l'inversion, et un dispositif d'écriture directement relié à l'encodeur. L'invention concerne également un dispositif d'électroformage à travers des écritures dans une telle mémoire résistive et un procédé de vérification d'écriture.

_200_

```
┌─────────────────────────────────────────────────────────────┐
│ 210   requérir une écriture dans le dispositif mémoire à une │
│       adresse initiale correspondant à la sélection de       │
│       plusieurs résistors                                    │
└─────────────────────────────────────────────────────────────┘
                            │
                            ▼
┌─────────────────────────────────────────────────────────────┐
│ 220   encoder les bits de données avec ledit code correcteur │
│       d'erreur linéaire et invariant à l'inversion           │
└─────────────────────────────────────────────────────────────┘
                            │
                            ▼
┌─────────────────────────────────────────────────────────────┐
│ 230   réaliser l'écriture du mot de code dans les résistors  │
│       sélectionnés avec un contrôleur mémoire réalisant une  │
│       écriture en mode 1T1R                                  │
└─────────────────────────────────────────────────────────────┘
```

**FIGURE 2**

EP 4 202 935 A1

**Description**

**Domaine de l'invention**

La présente invention concerne un procédé d'électroformage d'une mémoire résistive. Particulièrement, l'invention concerne un procédé d'électroformage d'une mémoire résistive couplée à un contrôleur mémoire.

**Etat de la technique**

Les mémoires résistives sont des mémoires non-volatiles présentant une densité élevée, une faible consommation d'énergie électrique et pouvant présenter une grande durée de vie selon les conditions d'utilisation.

Il existe plusieurs technologies de mémoires résistives. On peut notamment citer les mémoires résistives à pont conducteur, également appelées CBRAM (pour « Conductive-Bridging Random-Access Memory » selon la terminologie anglo-saxonne), ou les mémoires résistives à base d'oxyde, également appelées OxRAM (pour « Oxide-based Random-Access Memory » selon la terminologie anglo-saxonne) ou encore les mémoires à changement de phase, également appelées PCM (pour « Phase Change Memory »).

Une mémoire résistive (aussi appelée mémoire RRAM) est composée d'une multitude de cellules mémoires résistives agencées en lignes et colonnes de manière à former une matrice. Une cellule mémoire RRAM est dotée d'au moins un élément résistif dont on peut modifier la conductance.

Typiquement, une cellule mémoire RRAM est constituée d'un empilement métal isolant métal et présente, dans son état initial, un état de haute résistance (HRS) (pour « High Résistance State » selon la terminologie anglo-saxonne). Avant leur utilisation, certains types de mémoire résistive, telle que les mémoires OxRAM ou CBRAM nécessitent une activation électrique ou autrement dit un « électroformage ». L'application d'une impulsion haute tension à travers la cellule RRAM permet la formation de chemins conducteurs dans la couche de commutation (partie isolante) et conduit à « commuter » la cellule RRAM dans un état à faible résistance (LRS) (pour « Low Résistance State » selon la terminologie anglo-saxonne), correspondant à une rupture partielle de la structure isolante, ou autrement dit à la formation d'un « filament » conducteur à travers l'oxyde.

Le processus général de cette « rupture » de la couche isolante de la cellule est généralement appelé « électroformage » (ou « forming » selon la terminologie anglo-saxonne) et est réalisé préalablement à l'utilisation de la mémoire RRAM. Suite à ce processus d'« électroformage », l'application d'une tension appropriée (et significativement inférieure à l'impulsion haute tension) pendant une durée prédéfinie permet selon les cas soit de réduire la « longueur » du filament conducteur, entraînant un état de résistance HRS, soit de rallonger le chemin conducteur, entraînant un état de résistance LRS. Ces opérations sont connues de l'homme de l'art selon l'anglicisme « SET » ou « RESET ». Le matériau diélectrique disposé entre deux électrodes conductrices de la cellule est alors capable de basculer de manière réversible entre les deux états de résistance HRS et LRS, ces états permettant de stocker un bit d'information dans la cellule mémoire.

Une cellule mémoire résistive élémentaire est constituée généralement d'un transistor (1T) et d'un composant résistif ou résistor (1R), où un bit d'information est encodé à travers la valeur de la résistance électrique du résistor. Pour ces cellules élémentaires dites 1T1R, un '0' logique peut être encodé par exemple en programmant le résistor dans un état de résistance haute HRS et un '1' logique peut être encodé en programmant le résistor dans un état de résistance basse LRS, et l'on parle alors d'encodage en mode 1T1R.

Cependant, l'écart entre la plus faible valeur de résistance correspondant à un niveau LRS et la plus haute valeur de résistance correspondant au niveau HRS, également appelé « fenêtre mémoire », est souvent faible. Dès lors, on utilise couramment un « encodage différentiel » pour coder une valeur binaire à mémoriser. Un bit d'information peut être encodé dans une cellule mémoire dite 2T2R, composée de deux cellules élémentaires 1T1R, comprenant 2 transistors (2T) et 2 résistors (2R), et l'on parle alors d'encodage en mode 2T2R.

Comme chacun des états LRS et HRS peut être associé à une valeur logique, i.e. 1 ou 0, on peut considérer que dans une cellule 2T2R un des deux éléments résistifs encode le bit à programmer en version non-inversée tandis que l'autre élément résistif encode le même bit en version inversée. Par exemple, un '1' logique est encodé en programmant le résistor de la première cellule 1T1R dans un état de résistance haute HRS et le résistor de la deuxième cellule 1T1R dans un état de résistance basse LRS, et un '0' logique est encodé en programmant le résistor de la première cellule 1T1R dans un état de résistance basse LRS et le résistor de la deuxième cellule dans un état de résistance haute HRS.

Ainsi en encodage différentiel, chaque bit d'information est encodé dans une cellule élémentaire 2T2R formée de deux éléments résistifs qui sont écrits en opposition d'état, c'est-à-dire un des éléments résistifs écrit avec un niveau HRS et l'autre avec un niveau LRS. Les niveaux respectifs de résistance des deux éléments résistifs sont déterminés toujours dans le même ordre entre les deux éléments, et définissent si l'on est en présence d'un '1' ou d'un '0' logique suivant qu'il correspond aux états HRS-LRS ou LRS-HRS.

Lors d'une opération d'écriture dans une cellule mémoire 1T1R ou 2T2R, il faut s'assurer que chaque résistance électrique qui doit être programmée à un état HRS ou LRS est respectivement soit plus grande, soit plus petite qu'une valeur de référence $R_{REF}$. La comparaison d'une résistance électrique avec la valeur $R_{REF}$ est faite par une opération de lecture au cours de laquelle la résistance programmée est comparée à la valeur R$_{REF}$ à l'aide d'un amplificateur de détection ou SA (pour « Sense Amplifier» selon la terminologie anglo-saxonne). Par la suite, cette opération de lecture avec comparaison à une valeur de référence est appelée mode 1T1R.

Toutes les opérations de lecture dans les mémoires 1T1R sont effectuées en mode 1T1R. Pour lire la donnée stockée dans une cellule RRAM, une petite tension de lecture qui ne perturbe pas l'état courant de la cellule est de préférence appliquée pour déterminer dans quel état logique est la cellule.

Dans les mémoires où l'information est encodée en mode 2T2R, les opérations de lecture sont généralement effectuées en mode 2T2R aussi appelé lecture en mode différentiel. Les valeurs des deux résistances présentes dans une cellule mémoire 2T2R peuvent être comparées entre elles à l'aide d'un amplificateur de détection SA différentiel consistant à comparer les deux valeurs de résistance composant la cellule mémoire. On notera également que le dispositif de lecture peut également être prévu pour réaliser une lecture de chaque résistor d'une cellule, de façon individuelle, en comparant la résistance de chaque résistor à une valeur de référence. La présence d'un tel dispositif de lecture « unique » est couramment utilisée dans les opérations d'électroformage pour pouvoir vérifier le niveau de résistance de chaque résistor individuellement.

Une technique de lecture d'une donnée stockée dans une cellule mémoire 2T2R est décrite dans le document : « Hybrid Analog-Digital Learning with Differential RRAM synapses » de Bocquet et al. IEDM19-534. Elle utilise un circuit de lecture doté d'un amplificateur de détection de type à verrouillage qui, lors d'une opération de lecture, est couplé à la paire différentielle d'éléments résistifs par l'intermédiaire d'une paire de lignes de bits et est dotée de nœuds dont les potentiels basculent en fonction de valeurs de courant qui traversent les éléments résistifs. Ce type d'amplificateur de détection est réalisé avec peu de transistors et fonctionne comme un amplificateur différentiel de courant à fort gain. Il permet de comparer directement des courants qui traversent les éléments résistifs et circulent via des lignes de bits.

On notera que les mémoires comprenant des cellules 2T2R sont généralement pourvues d'un dispositif d'écriture des résistors de chaque cellule qui réalise en pratique deux écritures 1T1R pour écrire chacun des résistors à l'état qui doit être le sien (rappel : deux états différents pour les résistors d'une cellule différentielle 2T2R).

Étant donné que les éléments résistifs conservent leurs valeurs respectives même après la suppression de la tension appliquée, la mémoire résistive RRAM fait partie des mémoires non volatiles. Cependant, certains usages d'une mémoire impliquent de fréquentes transitions entre les états HRS et LRS pouvant introduire des dommages, les valeurs des résistances programmées pouvant changer à cause de phénomènes de relaxation, et entraîner alors une dégradation des performances de la RRAM.

Le temps de rétention de l'information dans une mémoire résistive dépend alors (a) des opérations de lecture, (b) des températures d'utilisation et/ou (c) des champs magnétiques élevés dans le cas des mémoires magnétiques.

Les variations de tensions de commutations et la non-uniformité cellule à cellule entrainent que les résistances qui sont programmées dans l'état LRS peuvent dériver vers un état HRS ou inversement. Dès lors, ce glissement des valeurs des résistances programmées peut engendrer des erreurs lors des opérations de lecture, et diminuer la performance des mémoires.

Pour réduire le taux d'erreur des mémoires RRAM, une solution couramment utilisée consiste à utiliser un code correcteur d'erreurs ou ECC (pour « Error Correcting Code » selon la terminologie anglo-saxonne) qui encode les données avant leur écriture en mémoire. Généralement, l'encodeur ECC est situé à l'intérieur ou à proximité du contrôleur mémoire. Un contrôleur mémoire selon la présente invention est un circuit électronique dont la fonction est de traduire des requêtes, en général en provenance d'un système électronique hôte, d'électroformage, de lecture ou d'écriture sur des mémoires résistives.

Lors de l'encodage de données avec un code ECC, des bits de vérification sont ajoutés aux bits de données, les bits de vérification représentant une information redondante calculée à partir des bits de données, qui permet la détection et la correction des erreurs affectant aussi bien les bits de données que les bits de vérification. L'ensemble des bits de données et des bits de vérification forme un mot de code.

La génération de ces bits de vérification est effectuée de façon transparente pour l'utilisateur de la mémoire. Lors d'une opération d'écriture en mémoire, l'encodeur ECC interne à la mémoire prépare le mot de code et l'ensemble des bits du mot de code sont écrits dans des cellules mémoire 2T2R, en réalisant pour chaque cellule mémoire une opération de SET pour un des résistors et une opération de RESET pour l'autre des résistors (chaque opération étant généralement réalisée en mode écriture 1T1R). Lors de l'étape d'électroformage préalablement à l'utilisation de la mémoire, on réalise l'équivalent d'une opération SET pour chaque résistor en écrivant un « 1 » dans chaque résistor. Cette écriture lors de l'étape d'électroformage diffère essentiellement d'une autre écriture (après électroformage) par les conditions de tension-courant qui sont appliquées, néanmoins, au niveau du contrôleur mémoire, c'est bien une écriture d'un « 1 » qui est demandé pour chaque résistor en cours d'électroformage.

Dans les mémoires RRAM connues utilisant un encodeur ECC les bits de la mémoire encodant les ECC sont généralement positionnés dans des emplacements particuliers, en général de façon regroupée. Le dispositif d'écriture des cellules dédiées aux bits ECC comprend généralement un mode d'écriture particulier pour l'étape d'électroformage afin de pouvoir « imposer » la valeur « 1 » à écrire lors de l'opération d'écriture spéciale que constitue l'étape d'électroformage (avec les conditions de courant/tension spécifique). Ce dispositif d'écriture avec son mode d'écriture dédié aux bits ECC est en pratique plus complexe que le dispositif d'écriture pour le reste de la matrice mémoire, car il doit pouvoir être commandé afin de prendre en entrée soit les valeurs d'ECC calculées par l'encodeur lors d'une opération d'écriture classique (hors électroformage), soit des valeurs imposées (valeurs à « 1 ») lors d'une opération d'écriture spéciale d'électroformage pour chacun des résistors des cellules mémoires.

Ainsi, il existe un besoin de pouvoir simplifier le dispositif d'écriture des bits ECC pour éviter cette complexité de la gestion des valeurs à prendre en entrée, qui se traduit par une surface mémoire plus grande et par un contrôle de la mémoire plus compliqué afin de réaliser l'ensemble des opérations d'électroformage de toutes les cellules de la mémoire.

Par ailleurs, il est aussi souhaitable de pouvoir s'assurer qu'il n'y a pas de résistor défaillant entraînant toujours une lecture d'une valeur logique « 1 » ou « 0 » lors de lectures de vérifications. Aussi, il existe un besoin de test après une opération d'électroformage, qui permet de vérifier la bonne réalisation de l'électroformage, et ceci sans complexifier le dispositif mémoire.

**Description brève de l'invention**

L'invention vise à pallier tout ou partie des problèmes cités plus haut en proposant un procédé d'électroformage utilisant un ECC linéaire invariant à l'inversion. Ainsi, l'invention vise à s'affranchir d'étapes supplémentaires pour effectuer l'électroformage de cellules mémoires, ou d'une complexification d'un système d'écriture.

A cet effet, l'invention a pour objet un procédé d'électroformage d'une mémoire résistive d'un dispositif mémoire incluant un contrôleur mémoire, un encodeur calculant un code correcteur d'erreur linéaire et invariant à l'inversion, et un dispositif d'écriture relié à l'encodeur, le procédé comprenant les étapes telles que récitées dans la revendication indépendante.

Avantageusement, le procédé comprend des étapes ultérieures récitées dans les revendications dépendantes.

Un autre objet de l'invention concerne un dispositif d'électroformage comprenant des moyens pour mettre en œuvre les étapes du procédé d'électroformage.

Avantageusement, les moyens comprennent un processeur hôte et les étapes du procédé d'électroformage sont mises en œuvre par des interactions entre le processeur hôte et le contrôleur mémoire.

Avantageusement, le code correcteur d'erreur linéaire et invariant à l'inversion est de type SEC, SEC-DED, DEC, DEC-TED, TEC, TEC-QED...

L'invention concerne également un procédé de vérification d'écriture dans une mémoire résistive d'un dispositif mémoire incluant un contrôleur mémoire et un encodeur calculant un code correcteur d'erreur linéaire et invariant à l'inversion, le procédé comprenant les étapes suivantes :

- requérir une lecture d'un mot de code écrit à une adresse initiale et vérifier si tous les bits de ce mot de code ont tous une même valeur logique parmi deux valeurs logiques « 0 » et « 1 » possibles :

- si tous les bits de ce mot de code ont tous la même valeur logique « 0 » ou « 1 », lire un registre de statut du contrôleur mémoire pour vérifier la présence ou non d'une erreur corrigeable ou non-corrigeable dans le mot qui vient d'être lu ; et selon le résultat de la vérification :

  ○ signaler une erreur d'écriture ; ou

  ○ terminer le procédé.

- si tous les bits de ce mot de code n'ont pas tous la même valeur logique « 0 » ou « 1 », signaler une erreur d'écriture.

Avantageusement, les étapes du procédé de vérification d'écriture sont mises en œuvre pour la vérification de l'écriture d'un mot de code d'une opération d'électroformage.

Avantageusement, les étapes du procédé de vérification d'écriture sont mises en œuvre pour la vérification de l'écriture d'un mot de code après des étapes consistant à :

- requérir une écriture dans le dispositif mémoire à une adresse initiale correspondant à la sélection de plusieurs résistors, avec des données à écrire comprenant k bits de données et présentant tous une même première valeur logique parmi deux valeurs logiques possibles « 0 » ou « 1 » ;

- encoder les k bits de données avec le code correcteur d'erreur linéaire et invariant à l'inversion de manière à obtenir un mot de code comprenant les bits de données et r bits de vérification, tel que les bits de vérification dépendent d'un nombre impair des bits de données résultant en ce que les bits de données et les bits de vérification ont tous la même première valeur logique ; et

- réaliser l'écriture du mot de code dans les résistors sélectionnés de ladite mémoire résistive, le contrôleur mémoire réalisant une écriture en mode 1T1R ou 2T2R du mot de code dans les résistors sélectionnés.

L'invention concerne également un dispositif de vérification d'écriture dans une mémoire résistive d'un dispositif mémoire incluant un contrôleur mémoire, un encodeur calculant un code correcteur d'erreur linéaire et invariant à l'inversion et un décodeur associé, le dispositif mémoire étant relié à un processeur externe, le dispositif de vérification comprenant des moyens pour mettre en œuvre les étapes du procédé de vérification d'écriture.

**Brève description des figures**

D'autres caractéristiques, détails et avantages de l'invention ressortiront à la lecture de la description faite en référence aux dessins annexés donnés à titre d'exemple et qui représente :

La figure 1 représente un système général qui utilise une mémoire résistive et permet de mettre en œuvre les étapes d'un procédé d'électroformage d'une mémoire résistive selon un mode de réalisation de l'invention.

La figure 2 représente un procédé d'électroformage d'une mémoire résistive d'un dispositif mémoire incluant un contrôleur mémoire et un encodeur calculant un code correcteur d'erreur linéaire et invariant à l'inversion.

La figure 3 détaille des étapes du procédé d'électroformage de la figure 2.

La figure 4 représente un procédé de vérification d'une opération d'électroformage, et en particulier un électroformage réalisé selon le procédé des figures 2 ou 3.

La figure 5 est une illustration d'une matrice de parité H pour un code correcteur d'erreur avec 3 bits de données.

**Description détaillée de l'invention**

Face au problème énoncé précédemment de simplifier les opérations d'électroformage des cellules mémoires codant les bits d'ECC, différentes approches peuvent être envisagées.

On pourrait envisager de ne pas avoir de dispositif d'écriture spécifique pour les bits ECC et d'avoir un dispositif d'écriture qui prenne uniquement en entrée les mots de code fournis par l'encodeur, sans avoir de mode spécifique de « bypass » des valeurs à écrire dans les bits ECC en mode d'électroformage. Ainsi, on peut rechercher une donnée à écrire qui une fois passée dans l'encodeur conduise à un mot de code dont les bits ECC présentent tous la valeur « 1 » permettant de réaliser l'électroformage de ces bits ECC. Néanmoins, une telle donnée peut ne pas exister selon le type d'encodeur choisi. En outre, il est peu probable que la donnée d'entrée identifiée soit elle-même une suite uniquement de valeurs « 1 » permettant de réaliser l'opération d'électroformage simultanément des cellules non ECC. Ainsi, il serait très vraisemblablement nécessaire de doubler le nombre d'opérations de programmation de la cellule mémoire pour réaliser une première écriture visant l'électroformage des cellules non ECC (avec une écriture de valeur « 1 » pour ces cellules) et une deuxième écriture d'électroformage visant les cellules ECC. Un inconvénient de ce procédé est que les cellules mémoires subiraient deux fois les impulsions de haute tension nécessaire à l'électroformage, ce qui pourrait les fragiliser.

Une autre piste possible est de choisir un encodeur qui permette d'avoir des bits ECC tous à « 1 » pour une donnée d'entrée qui correspond à une séquence de valeurs « 1 ». Cette piste est possible si on utilise un encodeur qui mette en œuvre un code correcteur particulier comme cela apparaîtra ci-après.

Par « code correcteur binaire linéaire», il est entendu un ensemble de mots de code qui sont générés en rajoutant un nombre défini (r) de bits de vérification à une pluralité k de bits de données, les bits de vérification étant générés à partir des bits de données en respectant l'équation suivante :
[Math. 1]

## Equation (1)

$$H \cdot v = 0$$

Où *v est un vecteur colonne* correspond à un mot de code (k bits de données et r bits de vérification) et *H* correspond à une matrice de parité, la matrice de parité comprenant uniquement des valeurs binaires ('0' ou '1'), chaque colonne de la matrice étant différente des autres colonnes, et chaque colonne de la matrice comprenant au moins une valeur différente de 0.

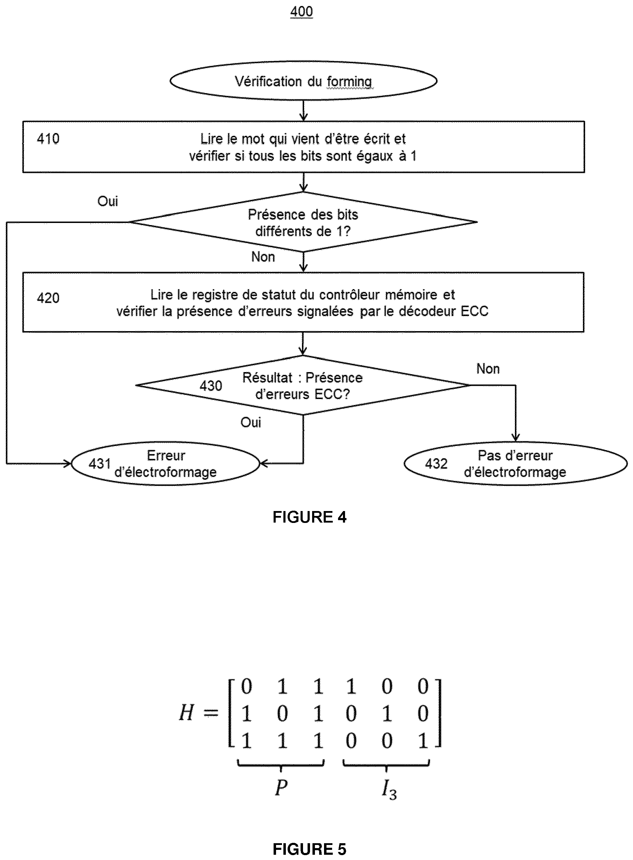

Les codes correcteurs linéaires systématiques sont définis à l'aide d'une matrice de parité $H = [P, I_r]$ composée d'une sous-matrice P où chaque colonne correspond à des bits de données, et d'une sous-matrice d'identité $I_r$ où chaque colonne correspond à des bits de vérification. La figure 5 illustre une matrice de parité *H* pour un code correcteur linéaire binaire avec 3 bits de données (k=3) et 3 bits de vérification (r=3). Les premières 3 colonnes correspondent à la sous-matrice P et les dernières 3 colonnes à la sous-matrice $I_r$ pour régal à 3.

L'exemple présenté en figure 5 correspond à un code correcteur systématique, i.e., chaque mot de code *v* est divisé en un vecteur de bits de données *d* et un vecteur de bits de vérification cet peut être noté :
[Math. 2]

Equation (2)

$$v = \begin{pmatrix} d1 \\ d2 \\ d3 \\ c1 \\ c2 \\ c3 \end{pmatrix}$$

Ce mot de code doit satisfaire l'équation (1) et les bits de vérification sont par exemple calculés de la façon suivante : c1 = d2 + d3 ; c2 = d1 + d3 ; c3 = d1 + d2 + d3, chaque bit de vérification correspondant à une valeur congrue à la somme modulo 2 (donc chaque bit de vérification ayant une valeur binaire, '0' ou '1'). Dans l'exemple de la matrice de la figure 5, les bits de vérification c1 et c2 sont pairs (car liés à deux valeurs de bits de données), le bit c3 est un bit de vérification impair (car lié à trois valeurs de bits de données).

Ainsi, selon cet exemple, si tous les bits de données sont inversés, c1 et c2 préserveront leurs valeurs alors que la valeur de c3 sera inversée. Ceci est particulièrement dû au fait que c3 dépend d'un nombre impair de bits de données.

Un ECC binaire linéaire est dit « invariant à l'inversion » lorsque l'inversion de tous les bits de données d'un mot de code nécessite l'inversion de tous les bits de vérification afin d'obtenir un nouveau mot de code. Ainsi et suivant ce qui a été rappelé précédemment, un ECC binaire linéaire est invariant à l'inversion lorsque tous les bits de vérification dépendent d'un nombre impairs de bits de données. Il résulte qu'avec un ECC linéaire et invariant à l'inversion, tous les bits de vérification deviennent 0 ou 1 si tous les bits de données sont respectivement égaux à 0, 1. Par conséquent, un ECC linéaire et invariant à l'inversion contient un mot de code ou tous les bits sont égaux 0 et un autre mot de code ou tous les bits sont égaux 1.

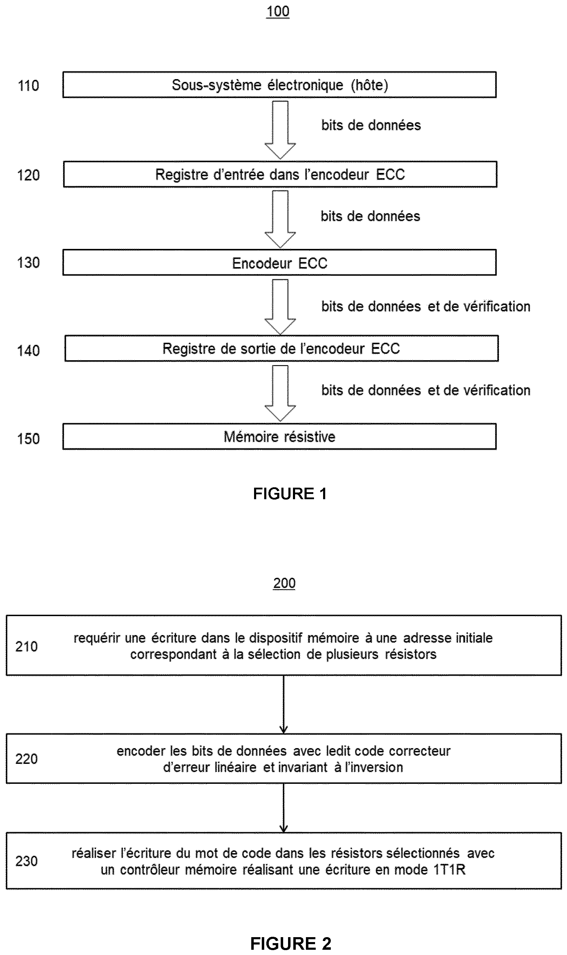

La figure 1 représente un système général 100 qui utilise une mémoire résistive et permet de mettre en œuvre les étapes d'un procédé d'électroformage d'une mémoire résistive selon un mode de réalisation de l'invention. Le système comprend un sous-système électronique 110, aussi appelé sous-système électronique hôte, un contrôleur mémoire 112 comprenant un encodeur de code correcteur d'erreur 130 (appelé encodeur ECC) ayant un registre d'entrée 120 et un registre de sortie 140, et une mémoire résistive 150. Le sous-système électronique hôte peut comprendre un ou plusieurs cœurs de processeur, un microcontrôleur et un circuit logique programmable aussi appelé FPGA (acronyme de l'anglais « Field Programmable Gate Array »). En plus ou alternativement, le sous-système hôte peut correspondre à un circuit intégré ASIC (acronyme de l'anglais « Application-Specific Integrated Circuit »).

Lors d'une opération d'électroformage, comme pour une opération d'écriture et de lecture, d'une mémoire résistive telle que celle comprise dans le système général 100, des bits de données sont émis par le sous-système électronique 110 et envoyé au contrôleur mémoire par l'intermédiaire du registre d'entrée dans l'encodeur ECC. Un contrôleur mémoire pilote l'opération de programmation nécessaire à l'opération d'électroformage, ainsi que les futures opérations d'écriture et de lecture dans la mémoire résistive. Les opérations de programmation sont effectuées selon les bits de données d'un mot émis par le sous-système électronique 110. Le contrôleur mémoire 112 comprend un encodeur et un décodeur ECC, l'encodeur étant utilisé lors d'une opération d'écriture (ou de programmation) et le décodeur utilisé lors d'une phase de lecture. Les bits de données d'un mot émis par le sous-système électronique 110 sont d'abord utilisés par l'encodeur ECC qui génère des bits de vérification qui sont ajoutés à la suite des bits de données afin de former un mot de code. Tous les bits du mot de code seront programmés/écrits à la même adresse lors d'une procédure d'électroformage ou d'écriture. Ces bits de vérification pourront notamment être utilisés par un décodeur ECC pour corriger d'éventuelles erreurs de stockage d'un mot dans la mémoire résistive lors d'une opération de lecture.

La figure 2 représente un procédé d'électroformage 200 d'une mémoire résistive d'un dispositif mémoire tel que par exemple celui de la figure 1 incluant un contrôleur mémoire et un encodeur calculant un code correcteur. Le procédé comprend une étape 210 de requête d'une écriture de données dans le dispositif mémoire à une adresse initiale qui correspond à la sélection de plusieurs cellules mémoires, i.e. pour écrire les résistors correspondants. Ces données à écrire comprennent k bits de données qui présentent tous une même première valeur logique, dite d'électroformage, sélectionnée parmi les deux valeurs logiques « 0 » et « 1 ».

Le procédé selon la figure 2 se poursuit par une étape 220 d'encodage des bits de données avec un code correcteur d'erreur linéaire et invariant à l'inversion, résultant en un mot de code comprenant les k bits de données et r bits de vérification. Les bits de vérification dépendent d'un nombre impair de bits de données, ce qui implique que les bits de données et les bits de vérification ont tous la même première valeur logique (toujours sélectionnée parmi les deux valeurs logiques « 0 » et « 1 »).

Le procédé selon la figure 2 se poursuit par une étape 230 d'écriture du mot de code obtenu à l'étape précédente dans les résistors sélectionnés de la mémoire résistive. Le contrôleur mémoire réalise cette opération en mode 1T1R par l'écriture individuelle de chaque résistor, les plaçant dans des états HRS ou LRS selon la valeur logique respective de chaque bit du mot de code et selon des conditions d'écriture permettant un électroformage, c'est-à-dire notamment selon une haute tension.

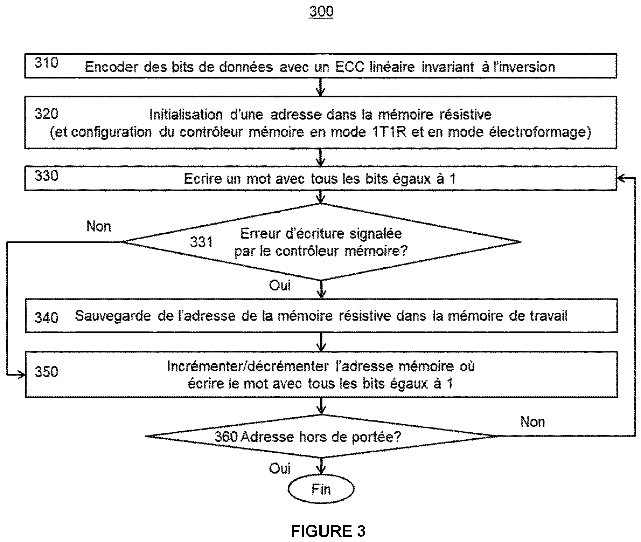

La figure 3 détaille des étapes du procédé d'électroformage décrit précédemment, pour une mémoire résistive couplée à un contrôleur mémoire et ayant des données protégées par un code correcteur d'erreur linéaire et invariant à l'inversion. Le procédé d'électroformage 300 comprend une étape 310 consistant à encoder des bits de données égaux à 1 avec un code correcteur d'erreur (ECC) linéaire et invariant à l'inversion.

A la suite de l'encodage de ces bits de donnés et l'obtention d'un mot de code, le procédé comprend une étape 320 consistant à initialiser l'adresse d'électroformage dans la mémoire résistive à une première valeur correspondant par exemple à la plus petite valeur d'adresse parmi les valeurs d'adresse permettant de sélectionner une cellule mémoire. En outre, lors de l'étape 320, le contrôleur mémoire est configuré en mode d'écriture 1T1R et en mode électroformage pour cette opération d'écriture « spéciale électroformage ». Il est notamment indiqué que la configuration du contrôleur mémoire est en 1T1R car le procédé d'électroformage est également nécessaire pour des mémoires résistives différentielles qui doivent être programmées en mode 1T1R lors des opérations d'électroformage.

L'étape d'initialisation 320 d'une adresse dans la mémoire résistive et de configuration du contrôleur mémoire en mode 1T1R et l'étape d'encodage 310 de bits de données avec un ECC linéaire et invariant à l'inversion sont des étapes qui peuvent être alternées chronologiquement ou réalisées en parallèle selon l'organisation matérielle du circuit, et notamment les moyens de commande utilisés par l'hôte pour commander le contrôleur mémoire, et éventuellement l'encodeur.

Le procédé d'électroformage se poursuit avec une étape 330 consistant à écrire dans la mémoire résistive selon ledit mot de code à ladite adresse d'électroformage. Le fait d'avoir configuré le contrôleur mémoire en mode électroformage garantit que l'opération d'écriture s'effectuera en appliquant des impulsions haute tension nécessaires à l'électroformage de cellules d'une mémoire résistive.

Dans le procédé d'électroformage de la présente invention, cette étape 330 consistant à écrire dans la mémoire résistive des bits de données égaux à 1 qui sont encodés avec un ECC linéaire et invariant à l'inversion garantit le fait que le mot de code écrit dans la mémoire aura tous ses bits égaux à 1. L'écriture d'un mot de code avec tous les bits égaux à 1 en mode 1T1R se traduira par une programmation à LRS de toutes les résistances des cellules mémoire à l'adresse indiquée. Le mode électroformage du contrôleur mémoire garantit l'exécution d'une opération d'électroformage sur les cellules mémoire à l'adresse indiquée.

Le procédé d'électroformage d'une mémoire résistive selon la figure 3 se poursuit avec une étape 331 consistant à vérifier à l'adresse d'électroformage dans la mémoire résistive que ledit mot de code a été bien programmé et, par conséquent, que les cellules mémoire ont été bien électro-formées. Cette étape peut être exécutée par le processeur hôte à travers une opération de lecture à l'adresse d'électroformage. Une erreur d'électroformage pourra être identifiée par l'hôte à travers l'identification des bits qui ne sont pas égaux à 1. L'hôte doit aussi vérifier si le contrôleur mémoire n'a pas signalé des erreurs, notamment des erreurs détectées par le décodeur lors de l'étape de lecture post-formage. Cette vérification d'erreurs de lecture éventuelle peut être faite soit par un signalement d'une erreur de lecture envoyé par le contrôleur mémoire à l'hôte, soit par une action de l'hôte consistant à vérifier des registres de statut du contrôleur mémoire. Dans le deuxième cas, on suppose que l'adresse de toute erreur corrigeable ou non-corrigeable identifiée par le décodeur ECC sera sauvegardée dans un registre de statut du contrôleur mémoire, et/ou dans un registre d'un processeur externe relié au dispositif mémoire. Si une erreur d'écriture a été identifiée, le procédé d'électroformage se poursuit par une étape 340 consistant à sauvegarder ladite adresse d'électroformage « avec erreur » dans une mémoire dédiée, dite mémoire de travail, associée à l'hôte (et non représentée). De cette manière, il sera possible dans la suite de la procédure de réessayer l'électroformage des cellules de la mémoire résistives se trouvant aux adresses sauvegardées dans la mémoire de travail de l'hôte.

Que ce soit dans le cas d'une erreur d'écriture identifiée ou bien dans le cas où aucune erreur d'écriture n'a été identifiée, le procédé d'électroformage se poursuit avec une étape 350 consistant à incrémenter ou décrémenter l'adresse d'électroformage afin de générer une nouvelle adresse d'électroformage. Ainsi le procédé peut être poursuivi en réitérant l'étape 330 d'écriture dudit mot de code, dont tous les bits ont la valeur '1', à ladite adresse d'électroformage incrémentée ou décrémentée, de manière à former la totalité de la mémoire résistive.

Le procédé d'électroformage de la mémoire résistive selon la figure 3 se poursuit avec une étape 360 consistant à vérifier que l'adresse d'électroformage incrémentée ou décrémentée est comprise dans la portée de la mémoire résistive. Par « comprise dans la portée de la mémoire résistive » il est entendu que le procédé d'électroformage est envisagé selon une portion ou la totalité de la mémoire résistive et que les adresses d'électroformage ne peuvent dépasser le périmètre de ces portions ou de la totalité de la mémoire résistive.

Dans le cas où le résultat de la vérification est que la nouvelle adresse d'électroformage incrémentée ou décrémentée n'est pas comprise dans la portée de la mémoire résistive, alors le procédé d'électroformage peut se terminer. Dans le cas où le résultat de la vérification est que l'adresse d'électroformage incrémentée ou décrémentée est comprise dans la portée de la mémoire résistive, alors le procédé se poursuit avec la réitération de l'étape 330 consistant à former la mémoire résistive selon ledit mot de code à ladite adresse d'électroformage incrémentée ou décrémentée.

Dans un mode de réalisation, le procédé d'électroformage comprend l'étape ultérieure de fournir le mot de code lu à un décodeur apte à fournir k bits de données corrigées si nécessaire à partir des bits de vérification, le décodeur étant apte à renseigner un registre de statut du contrôleur mémoire indiquant la présence ou non d'une erreur corrigeable ou non-corrigeable dans le mot qui vient d'être lu, et où l'étape de comparaison de la valeur lue et de la valeur attendue inclut une opération de consultation dudit registre de statut du contrôleur.

La figure 4 représente des étapes d'un procédé 400 de vérification d'une opération d'électroformage, et en particulier un électroformage réalisé selon le procédé décrit précédemment en référence aux figures 2 et 3. Ces étapes peuvent être réalisées indépendamment ou en complément des étapes du procédé d'électroformage décrit.

Par ailleurs, ces étapes peuvent être réalisées comme un procédé de vérification d'écriture dans une mémoire résistive d'un dispositif mémoire incluant un contrôleur mémoire et un encodeur calculant un code correcteur d'erreur linéaire et invariant à l'inversion et un décodeur associé.

Le procédé 400 comprend une première étape 410 de lecture de vérification, consistant requérir, par un processeur externe, une lecture à l'adresse initiale et/ou à la nouvelle adresse et vérifier si tous les bits de données retournée audit processeur, obtenues en sortie d'un décodeur ayant reçu le mode de code lu, ont tous une même valeur logique parmi deux valeurs logiques « 0 » et « 1 » possibles.

Dans le cas où il est lu et vérifié que certains bits de données ont une valeur différente de la valeur logique '0' ou '1' (branche Oui de 412) attendue, alors le procédé se poursuit par une étape 431 consistant à signaler une erreur d'électroformage.

Dans le cas où il est lu et vérifié qu'aucun bit de ce mot de code n'a une valeur logique différente de '1' ou '0' de la valeur attendue (branche Non de 412), alors le procédé se poursuit par une étape 420 consistant à lire un registre de statut du contrôleur mémoire pour vérifier 430 la présence ou non d'une erreur ayant été corrigée par ledit décodeur dans le mot qui vient d'être lu (vérifier si le décodeur ECC a levé un drapeau (issu de l'anglicisme « flag ») indiquant la présence d'une erreur, corrigeable ou non-corrigeable dans le mot qui vient d'être lu).

Dans le cas (branche Non de 430) où le résultat est qu'il n'y a pas d'erreur (corrigeable ou non-corrigeable) indiqué par le registre du statut du contrôleur mémoire, le procédé se termine par une étape 432 consistant à conclure qu'il n'y a pas d'erreurs d'électroformage.

Dans le cas (branche Oui de 430) où le résultat est qu'il y a une erreur, corrigeable ou non-corrigeable, indiqué par le registre du statut du contrôleur mémoire, le procédé se poursuit par l'étape 431 consistant à prendre en compte l'erreur d'électroformage, i.e. en pratique à conserver l'adresse courante à laquelle une opération d'électroformage vient juste d'être réalisée et vérifiée. Ultérieurement, l'hôte pourra relancer une éventuelle opération d'électroformage à cette adresse, ou pourra éventuellement décider de ne pas utiliser les cellules mémoire situées à cette adresse ayant amené des erreurs.

De façon générale, les étapes décrites dans les logigrammes des figures 2 à 4 sont une description « haut niveau » des opérations de programmation et vérification que l'on souhaite réaliser dans une mémoire résistive. Néanmoins, ces opérations sont en pratique mises en œuvre par des interactions entre l'hôte 110 et le contrôleur mémoire 112. On notera que l'encodeur et le décodeur ECC sont généralement inclus dans les « frontières » du dispositif mémoire qui inclut par ailleurs, au-delà de la matrice de cellules mémoire, des dispositifs de contrôle lignes/colonnes, des dispositifs d'écriture et de lecture ainsi que le contrôleur mémoire. Les « frontières » du dispositif mémoire sont délimitées par les blocs d'entrée/sortie (ou I/O de l'anglais « Input/Output »). L'hôte qui requiert l'exécution d'un procédé d'électroformage peut être un processeur relié au dispositif mémoire par un bus « système » comprenant un bus de données, un bus d'adresse et des signaux de commande reliés aux blocs d'entrée/sortie de la mémoire.

Selon un mode de mise en œuvre du procédé d'électroformage, le processeur hôte envoie directement des commandes d'écriture et de lecture successives pour réaliser les opérations décrites en relation aux figures 2 à 4. Ainsi, pour réaliser l'équivalent des étapes 310 à 330, le processeur hôte envoie une instruction d'écriture au dispositif mémoire, avec un signal de contrôle du bus du dispositif mémoire lui indiquant qu'on est en mode « électroformage », en positionnant la valeur « 1 » sur le bus de données, et en positionnant l'adresse initiale sur le bus d'adresses. Sur réception de cette commande d'écriture, le dispositif mémoire, via son contrôleur mémoire, va lancer l'exécution du calcul de l'ECC par l'encodeur et va commander ensuite l'écriture à proprement parler du mot de code (avec des valeurs à 1) en activant les dispositifs de contrôle lignes/colonnes à partir de l'adresse reçue, et en activant les dispositifs d'écriture qui reçoivent pour consigne d'écriture le mot de code issu de l'encodeur.

Pour réaliser l'équivalent de l'étape 331, ou 410, le processeur hôte envoie une instruction de lecture au dispositif mémoire avec un signal de contrôle du bus du dispositif mémoire lui indiquant qu'on est en mode lecture, en positionnant l'adresse initiale sur le bus d'adresses et en attendant la donnée lue qui sera réceptionnée sur le bus de données. Sur réception de cette commande de lecture, le dispositif mémoire, via son contrôleur mémoire, va lancer l'exécution de la lecture à proprement parler du mot de code en activant les dispositifs de contrôle lignes/colonnes à partir de l'adresse reçue, puis transmettre le mot de code lu au décodeur. Le décodeur identifie s'il y a des erreurs dans la partie données du mot de code grâce aux bits d'ECC. S'il y a une erreur (ou plusieurs), le décodeur le signale au contrôleur mémoire, par exemple en écrivant dans un registre interne du contrôleur mémoire. En outre, s'il y a une erreur, le décodeur corrige les données si cela est possible. Si la correction de la donnée était possible ou s'il n'y avait pas d'erreurs, le décodeur fournit les données sur le bus de données via le bloc d'entrée-sortie. Le processeur hôte récupère les données présentes sur le bus et vérifie si ces données sont toutes égales à la valeur « 1 » qui doit correspondre à la valeur attendue après une étape d'électroformage.

Le processeur vérifie également qu'il n'y a pas eu de corrections d'erreurs réalisées par le décodeur (via, par exemple, la consultation du registre interne du contrôleur mémoire qui peut être rendu accessible au processeur hôte) avant de valider la bonne réalisation de l'électroformage à l'adresse courante.

Dans tous les exemples de réalisation précédemment décrits, il a été pris pour postulat que l'étape d'électroformage consiste à réaliser une opération de SET conduisant à écrire la mémoire résistive sélectionnée à un état de basse impédance LRS.

Il a également été considéré que les valeurs des données sortant de l'encodeur sont transmises au dispositif d'écriture et écrites dans la mémoire sélectionnée sans opération d'inversion de la valeur dans cette chaîne. Ainsi l'homme de l'art comprendrait qu'il faut adapter en conséquence la valeur de données indiquée par le processeur lors d'une requête d'écriture si par exemple un inverseur était placé en sortie du bloc encodeur, entre ce dernier et le dispositif d'écriture. Ainsi, l'homme de l'art pourra bien entendu envisager des adaptations du procédé et du dispositif précédemment décrits, pour conserver l'avantage de la présente invention, à savoir de ne pas avoir besoin d'un dispositif d'écriture des bits d'ECC spécifique (qui impliquerait alors d'avoir un bypass de l'encodeur pour les bits ECC en mode d'électroformage).

Dans la présente invention, le dispositif d'écriture pour les bits de données et d'ECC est directement relié à l'encodeur et reçoit comme consigne de valeurs d'écriture directement les valeurs issues de l'encodeur, sans qu'il y ait besoin de différencier ce mode de fonctionnement selon que l'on est en électroformage ou en écriture « standard ». Cet avantage de simplicité du dispositif mémoire est obtenu grâce à un encodeur mettant en œuvre un code correcteur d'erreur linéaire et invariant à l'inversion comme cela a été expliqué précédemment

Dans les exemples précédemment décrits, l'électroformage est normalement réalisé avec une unique écriture, en mode électroformage, pour faire passer chaque cellule mémoire dans l'état LRS. C'est notamment le cas pour les mémoires résistives du type CBRAM et OxRAM. Il est possible que pour d'autres types de mémoires résistives, il soit nécessaire de faire plusieurs opérations d'écriture pour bien réaliser l'opération d'électroformage. Dans le cas par exemple des mémoires PCM, il est nécessaire avant leur utilisation standard, de faire plusieurs cycles de SET et RESET dans des conditions d'écriture particulières (en tension/courant). Ainsi, dans ce cas, les logigrammes d'électroformage décrits précédemment doivent être adaptés pour réaliser, non pas une opération d'écriture, mais une série d'écriture pour écrire successivement « 1 » (faire un SET) puis « 0 » (faire un RESET), et recommencer plusieurs fois. A l'issue, de cette répétition d'écritures SET/RESET, on pourra de même vérifier que l'état d'écriture à « 0 » et/ou à « 1 » est correct. Là aussi, l'intérêt d'utiliser un encodeur mettant en œuvre un code correcteur d'erreur linéaire et invariant à l'inversion permet « naturellement », sans matériel, ni logiciel supplémentaire, de réaliser l'électroformage des bits ECC en même temps que l'électroformage des bits de données, ce qui permet d'être plus rapide au final, et d'éviter des « stress » inutiles aux cellules mémoire (qui seraient liés à des conditions de tension/courant néfastes pour les cellules si répétées plusieurs/trop de fois).

Dans les exemples décrits précédemment, l'étape d'électroformage unique réalisée vise à faire passer chaque résistor d'un état technologique initial (appelé « pristine » en anglais) qui présente une haute impédance « très HRS » à un état basse impédance LRS. En outre, nous avons pris pour convention que l'opération de SET est réalisée par demande d'écriture d'une valeur « 1 » dans la mémoire. Dans le cas où une convention inverse serait prise, à savoir écriture d'une valeur de « 0 » pour réaliser une opération de mise en état LRS (passage de HRS à LRS) et d'une valeur de « 1 » pour réaliser l'opération inverse de mise à l'état HRS, alors il est possible d'utiliser un encodeur mettant en œuvre un code correcteur linéaire « simple », sans qu'il soit nécessaire que le code correcteur linéaire soit également invariant à l'inversion.

On notera néanmoins, qu'au-delà d'une réalisation de l'étape d'électroformage au moyen d'un dispositif mémoire ne nécessitant pas d'avoir un encodeur qui puisse être contourné (« bypass » pour que le contrôleur mémoire puisse commander directement), il est intéressant de pouvoir réaliser des écritures de vérification de la matrice mémoire consistant à écrire un « 1 » dans toutes les cellules, puis un « 0 » dans toutes les cellules, y compris dans les cellules ECC, pas uniquement dans les cellules de données. Ces écritures de vérification permettent notamment de s'assurer qu'il n'y a pas de résistor défaillant entraînant toujours une lecture d'un « 1 » ou d'un « 0 ». Pour pouvoir réaliser ces vérifications, sans surcoût de matériel « hardware » embarqué dans le dispositif mémoire, et depuis le processeur hôte, il est nécessaire d'utiliser un encodeur qui mette en œuvre un code correcteur d'erreur linéaire et invariant à l'inversion. Ainsi, l'utilisation d'un tel encodeur permet en pratique de simplifier le dispositif mémoire, pour la réalisation des étapes d'électroformage et/ou pour la réalisation des étapes de test « tout à 1 » et « tout à 0 ».

Les différents modes de réalisation présentés dans cette description ne sont pas limitatifs et peuvent être combinés entre eux. En outre, la présente invention n'est pas limitée aux modes de réalisation précédemment décrits mais s'étend à tout mode de réalisation entrant dans la portée des revendications.

Sans limitation, un ECC connu est le code SEC-DED (acronyme de l'anglicisme « Single Error Correction Double Error Détection ») qui permet la correction des erreurs sur un seul bit (SEC) et la détection des erreurs sur deux bits (DED). L'homme du métier pourra se reporter à différents documents disponibles de la littérature qui décrivent des types de code correcteur d'erreurs et des mécanismes de correction et détection d'erreurs par un ECC dans une mémoire résistive.

**Revendications**

1. Procédé d'électroformage (200) d'une mémoire résistive d'un dispositif mémoire incluant un contrôleur mémoire, un encodeur calculant un code correcteur d'erreur linéaire et invariant à l'inversion, et un dispositif d'écriture directement relié à l'encodeur, le procédé comprenant les étapes suivantes :

   - (210) requérir une écriture dans le dispositif mémoire à une adresse initiale correspondant à la sélection de plusieurs résistors, avec des données à écrire comprenant k bits de données et présentant tous une même première valeur logique dite d'électroformage parmi deux valeurs logiques possibles « 0 » ou « 1 » ;
   - (220) encoder les k bits de données avec le code correcteur d'erreur linéaire et invariant à l'inversion de manière à obtenir un mot de code comprenant les bits de données et r bits de vérification, tel que les bits de vérification dépendent d'un nombre impair des bits de données résultant en ce que les bits de données et les bits de vérification ont tous la même première valeur logique ;
   - (230) réaliser, par le dispositif d'écriture directement relié à l'encodeur et recevant comme consigne de valeurs d'écriture directement les valeurs issues de l'encodeur, l'écriture du mot de code dans les résistors sélectionnés de ladite mémoire résistive, le contrôleur mémoire réalisant une écriture en mode 1T1R correspondant à une écriture individuelle de chaque résistor, chaque résistor étant placé dans un état de haute ou de basse impédance selon la valeur logique respective de chaque bit du mot de code, le contrôleur mémoire appliquant des conditions d'écriture permettant l'électroformage.

2. Procédé d'électroformage d'une mémoire résistive selon la revendication 1, le procédé comprenant les étapes ultérieures suivantes :

   - (331) requérir une lecture par le contrôleur mémoire à l'adresse initiale dans la mémoire résistive où ledit mot de code a été écrit et comparer la valeur lue à la valeur attendue, et si lesdites valeurs ne correspondent pas (340) sauvegarder ladite adresse d'électroformage dans un registre de statut du contrôleur mémoire et/ou dans un registre d'un processeur externe relié au dispositif mémoire,
   - (350) incrémenter ou décrémenter l'adresse initiale, de manière à obtenir une nouvelle adresse correspondant à la sélection d'autres résistors que ceux de l'adresse initiale ; et
   - (360) vérifier si cette nouvelle adresse est hors de portée :

      - si oui terminer le procédé ;
      - si non réitérer les étapes de la revendication 1 à la nouvelle adresse.

3. Procédé d'électroformage d'une mémoire résistive selon la revendication 1 ou 2, le procédé d'électroformage comprenant les étapes ultérieures suivantes :

   - fournir le mot de code lu à un décodeur apte à fournir k bits de données corrigées si nécessaire à partir des bits de vérification, le décodeur étant apte à renseigner un registre de statut du contrôleur mémoire indiquant la présence ou non d'une erreur corrigeable ou non-corrigeable dans le mot qui vient d'être lu ;
   - et dans lequel, l'étape de comparaison de la valeur lue et de la valeur attendue inclut une opération de consultation dudit registre de statut du contrôleur.

4. Procédé d'électroformage d'une mémoire résistive selon l'une quelconque des revendications précédentes, le procédé d'électroformage comprenant les étapes ultérieures suivantes :

   - (410) requérir, par un processeur externe, une lecture à l'adresse initiale et/ou à la nouvelle adresse et vérifier si tous les bits de données retournées audit processeur, obtenues en sortie d'un décodeur ayant reçu le mode de code lu, ont tous une même valeur logique parmi deux valeurs logiques « 0 » et « 1 » possibles ;
   - si tous les bits de données ont tous la même valeur logique « 0 » ou « 1 » attendue, (420) lire le registre de statut du contrôleur mémoire pour vérifier la présence ou non d'une erreur ayant été corrigée par ledit décodeur dans le mot qui vient d'être lu ; et selon le résultat (430) de la vérification :

      - (431) signaler une erreur d'électroformage ; ou
      - (432) terminer le procédé ;

   - si tous les bits de données n'ont pas tous la même valeur logique « 0 » ou « 1 », (431) signaler une erreur d'électroformage.

5. Procédé d'électroformage d'une mémoire résistive selon l'une quelconque des revendications précédentes, les étapes du procédé étant itérées au moins une fois avec des données à écrire dont la valeur logique des bits est différente de la valeur logique des bits de l'itération précédente.

6. Dispositif d'électroformage d'une mémoire résistive d'un dispositif mémoire incluant un contrôleur mémoire, un encodeur calculant un code correcteur d'erreur linéaire et invariant à l'inversion, et un dispositif d'écriture directement relié à l'encodeur, le dispositif d'électroformage comprenant des moyens pour mettre en œuvre les étapes du procédé d'électroformage selon l'une quelconque des revendications précédentes.

7. Dispositif selon la revendication 6 dans lequel les moyens comprennent un processeur hôte, les étapes du procédé d'électroformage selon l'une quelconque des revendications précédentes étant mises en œuvre par des interactions entre le processeur hôte et le contrôleur mémoire.

8. Le dispositif d'électroformage selon la revendication 6 ou 7 dans lequel le code correcteur d'erreur linéaire et invariant à l'inversion est de type SEC, SEC-DED, DEC, DEC-TED, TEC, TEC-QED...

9. Procédé de vérification d'écriture dans une mémoire résistive d'un dispositif mémoire incluant un contrôleur mémoire et un encodeur calculant un code correcteur d'erreur linéaire et invariant à l'inversion, le procédé comprenant les étapes suivantes :

    - (410) requérir une lecture d'un mot de code écrit à une adresse initiale, le mot de code ayant été écrit par un dispositif d'écriture directement relié à l'encodeur et ayant reçu comme consigne de valeurs d'écriture directement les valeurs issues de l'encodeur, et vérifier si tous les bits de ce mot de code ont tous une même valeur logique parmi deux valeurs logiques « 0 » et « 1 » possibles ;
    - si tous les bits de ce mot de code ont tous la même valeur logique « 0 » ou « 1 », (420) lire un registre de statut du contrôleur mémoire pour vérifier la présence ou non d'une erreur corrigeable ou non-corrigeable dans le mot qui vient d'être lu ; et selon le résultat (430) de la vérification :

        - (431) signaler une erreur d'écriture ; ou
        - (432) terminer le procédé ;

- si tous les bits de ce mot de code n'ont pas tous la même valeur logique « 0 » ou « 1 », (431) signaler une erreur d'écriture.

10. Le procédé selon la revendication 9 dans lequel les étapes sont mises en œuvre pour la vérification de l'écriture d'un mot de code d'une opération d'électroformage.

11. Le procédé selon la revendication 9 pour lequel les étapes sont mises en œuvre pour la vérification de l'écriture d'un mot de code après des étapes consistant à :

    - (210) requérir une écriture dans le dispositif mémoire à une adresse initiale correspondant à la sélection de plusieurs résistors, avec des données à écrire comprenant k bits de données et présentant tous une même première valeur logique parmi deux valeurs logiques possibles « 0 » ou « 1 » ;
    - (220) encoder les k bits de données avec le code correcteur d'erreur linéaire et invariant à l'inversion de manière à obtenir un mot de code comprenant les bits de données et r bits de vérification, tel que les bits de vérification dépendent d'un nombre impair des bits de données résultant en ce que les bits de données et les bits de vérification ont tous la même première valeur logique ; et
    - (230) réaliser l'écriture du mot de code dans les résistors sélectionnés de ladite mémoire résistive, le contrôleur mémoire réalisant une écriture en mode 1T1R ou 2T2R du mot de code dans les résistors sélectionnés.

12. Dispositif de vérification d'écriture dans une mémoire résistive d'un dispositif mémoire incluant un contrôleur mémoire, un encodeur calculant un code correcteur d'erreur linéaire et invariant à l'inversion et un décodeur associé, le dispositif mémoire étant relié à un processeur externe, le dispositif de vérification comprenant des moyens pour mettre en œuvre les étapes du procédé selon l'une quelconque des revendications 9 à 11.

100

| 110 | Sous-système électronique (hôte) |
|---|---|

bits de données

| 120 | Registre d'entrée dans l'encodeur ECC |
|---|---|

bits de données

| 130 | Encodeur ECC |
|---|---|

bits de données et de vérification

| 140 | Registre de sortie de l'encodeur ECC |
|---|---|

bits de données et de vérification

| 150 | Mémoire résistive |
|---|---|

FIGURE 1

200

| 210 | requérir une écriture dans le dispositif mémoire à une adresse initiale correspondant à la sélection de plusieurs résistors |
|---|---|
| 220 | encoder les bits de données avec ledit code correcteur d'erreur linéaire et invariant à l'inversion |
| 230 | réaliser l'écriture du mot de code dans les résistors sélectionnés avec un contrôleur mémoire réalisant une écriture en mode 1T1R |

FIGURE 2

<u>300</u>

| 310 | Encoder des bits de données avec un ECC linéaire invariant à l'inversion |

| 320 | Initialisation d'une adresse dans la mémoire résistive (et configuration du contrôleur mémoire en mode 1T1R et en mode électroformage) |

| 330 | Ecrire un mot avec tous les bits égaux à 1 |

331 Erreur d'écriture signalée par le contrôleur mémoire?  — Non

Oui

| 340 | Sauvegarde de l'adresse de la mémoire résistive dans la mémoire de travail |

| 350 | Incrémenter/décrémenter l'adresse mémoire où écrire le mot avec tous les bits égaux à 1 |

360 Adresse hors de portée? — Non

Oui

( Fin )

**FIGURE 3**

400

FIGURE 4

$$H = \begin{bmatrix} 0 & 1 & 1 & 1 & 0 & 0 \\ 1 & 0 & 1 & 0 & 1 & 0 \\ 1 & 1 & 1 & 0 & 0 & 1 \end{bmatrix}$$

$$\underbrace{\phantom{xxxxx}}_{P} \qquad \underbrace{\phantom{xxxxx}}_{I_3}$$

FIGURE 5

Europäisches
Patentamt

European
Patent Office

Office européen
des brevets

**RAPPORT DE RECHERCHE EUROPEENNE**

Numéro de la demande

**EP 22 21 2679**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | GHERMAN VALENTIN ET AL: "Binary Linear ECCs Optimized for Bit Inversion in Memories with Asymmetric Error Probabilities", 2020 DESIGN, AUTOMATION & TEST IN EUROPE CONFERENCE & EXHIBITION (DATE), EDAA, 9 mars 2020 (2020-03-09), pages 298-301, XP033781640, DOI: 10.23919/DATE48585.2020.9116531 | 9-12 | INV. G11C13/00 G06F11/10 G11C29/52 |
| A | * page 298, colonne de gauche, alinéa 1 – page 299, colonne de gauche, alinéa 4 * ----- | 1-8 | |
| A | EP 3 786 801 A1 (COMMISSARIAT ENERGIE ATOMIQUE [FR]) 3 mars 2021 (2021-03-03) * alinéa [0025] – alinéa [0050] * ----- | 1-12 | |
| A | US 2019/377631 A1 (HATTORI NORIO [JP]) 12 décembre 2019 (2019-12-12) * alinéas [0005], [0006], [0026] – [0042] * ----- | 1-12 | DOMAINES TECHNIQUES RECHERCHES (IPC) G11C G06F |

Le présent rapport a été établi pour toutes les revendications

| Lieu de la recherche | Date d'achèvement de la recherche | Examinateur |
|---|---|---|
| La Haye | 13 avril 2023 | Colling, Pierre |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 22 21 2679

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

13-04-2023

| Document brevet cité au rapport de recherche | Date de publication | Membre(s) de la famille de brevet(s) | Date de publication |
|---|---|---|---|
| EP 3786801 A1 | 03-03-2021 | EP 3786801 A1 | 03-03-2021 |
| | | FR 3100369 A1 | 05-03-2021 |
| | | US 2021067178 A1 | 04-03-2021 |
| US 2019377631 A1 | 12-12-2019 | CN 110580927 A | 17-12-2019 |
| | | JP 6612392 B1 | 27-11-2019 |
| | | JP 2019212356 A | 12-12-2019 |
| | | KR 20190139760 A | 18-12-2019 |
| | | TW 202001881 A | 01-01-2020 |
| | | US 2019377631 A1 | 12-12-2019 |
| | | US 2021096947 A1 | 01-04-2021 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **DE BOCQUET et al.** Hybrid Analog-Digital Learning with Differential RRAM synapses. *IEDM19-534*